Europäisches Patentamt

European Patent Office

Office européen des brevets

(11) Veröffentlichungsnummer: **0 416 522 A2**

## (12) EUROPÄISCHE PATENTANMELDUNG

(21) Anmeldenummer: **90116940.9**

(22) Anmeldetag: **01.09.90**

(51) Int. Cl.5: **H03K 17/16, H03K 17/13**

(30) Priorität: **08.09.89 DE 3929890**

(43) Veröffentlichungstag der Anmeldung:
**13.03.91 Patentblatt 91/11**

(84) Benannte Vertragsstaaten:
**DE FR GB IT NL**

(71) Anmelder: **TELEFUNKEN electronic GmbH**
**Theresienstrasse 2**
**W-7100 Heilbronn(DE)**

(72) Erfinder: **Rinderle, Heinz, Dipl.-Ing. (FH)**
**Goerdelerstrasse 82**
**W-7100 Heilbronn(DE)**
Erfinder: **Siegle, Martin, Dipl.-Ing. (FH)**
**Steinhaldestrasse 30**
**W-7100 Heilbronn-Frankenbach(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) **Schaltung zur Signalverarbeitung symmetrischer Signale.**

(57) Beschrieben wird eine Schaltung zur Signalverarbeitung symmetrischer Signale, die aus einem Signalverarbeitungsteil mit mindestens einem Eingang, an dem das zu verarbeitende Eingangssignal anliegt und mindestens einem Ausgang, an dem das verarbeitete Eingangssignal ansteht, sowie aus einem Logikteil mit mindestens einem Steuereingang, an dem ein Steuersignal anliegt, besteht und mindestens eine Steuerleitung besitzt, mit der Steuersignale zur Änderung der Signalverarbeitung vom Logikteil zum Signalverarbeitungsteil übertragen werden.

Um Störungen bei einer Änderung der Signalverarbeitung zu vermeiden, ist nach der Erfindung ein sowohl mit dem Ausgang des Signalverarbeitungsteils als auch mit dem Logikteil verbundener Entstörteil vorgesehen. Durch den Entstörteil wird der zeitliche Verlauf des verarbeiteten Eingangssignals derart erfaßt und dem Logikteil zugeführt, daß das durch Steuersignale ausgelöste Umschalten und/oder ein Wechsel der Verarbeitung der Eingangssignale nur im Nulldurchgang oder bei möglichst geringer momentaner Signalspannung des verarbeiteten Eingangssignals oder bei möglichst kleinen Momentanwertunterschieden zwischen dem in der Verarbeitung geänderten Signal sowie dem ungeänderten Signal am Schaltungsausgang auftritt.

FIG.1

EP 0 416 522 A2

## SCHALTUNG ZUR SIGNALVERARBEITUNG SYMMETRISCHER SIGNALE

Die Erfindung betrifft eine Schaltung zur Signalverarbeitung symmetrischer Signale gemäß dem Oberbegriff des Patentanspruchs 1.

In einer derartigen Schaltung werden Eingangssignale verarbeitet, beispielsweise verstärkt oder gefiltert, und ein Ausgangssignal, das verarbeitete Eingangssignal, ausgegeben.

Eine Änderung in der Signalverarbeitung, beispielsweise das Umschalten auf ein anderes Eingangssignal oder Pegelumschaltungen, wird zunehmend mit Hilfe der Digitaltechnik, beispielsweise mittels eines Logikteils, vorgenommen. Da das zeitlich frühere und das geänderte Eingangssignal, und demzufolge auch die verarbeiteten Eingangssignale, unterschiedliche Momentanwerte besitzen, und ein digitales Umschalten vom einen auf den anderen Wert instantan erfolgt, treten Sprünge im Signalverlauf des Ausgangssignals auf.

Diese Sprünge im Signalverlauf sowie eventuell auftretende Umschaltspitzen führen zu Störungen, die hörbar (Knacken im Lautsprecher) und meßbar sind. Hiervon betroffen sind beispielsweise Phasenänderungen bei Umschaltern oder Amplitudenänderungen bei Verstärkern; besonders gravierend sind diese Störungen, wenn die momentanen Unterschiede zwischen dem zeitlich früheren und dem geänderten Signal groß sind.

Der Erfindung liegt die Aufgabe zugrunde, eine Schaltung anzugeben, die ohne derartige Störungen arbeitet. Dies wird bei einer Schaltung nach dem Oberbegriff des Anspruchs 1 dadurch erreicht, daß ein sowohl mit dem Ausgang des Signalverarbeitungsteils als auch mit dem Logikteil verbundener Entstörteil vorgesehen ist, durch den der zeitliche Verlauf des verarbeiteten Eingangssignals derart erfaßt und dem Logikteil zugeführt wird, daß das durch Steuersignale ausgelöste Umschalten und/oder ein Wechsel der Verarbeitung der Eingangssignale nur im Nulldurchgang oder bei möglichst geringer momentaner Signalspannung des verarbeiteten Eingangssignals oder bei möglichst kleinen Momentanwertunterschieden zwischen dem in der Verarbeitung geänderten Signal sowie dem ungeänderten Signal am Schaltungsausgang auftritt.

Vorteilhafte Ausgestaltungen der Erfindung ergeben sich aus den Unteransprüchen.

Durch die zusätzliche Nachbereitung des Signals mit Hilfe des Entstörteils kann ein Auftreten der Störungen vermieden werden. Besitzt die Schaltung mehrere Ausgänge, ist vor jedem Ausgang ein derartiger Entstörteil vorgesehen.

Vorzugsweise wird die gesamte Schaltung mit dem Entstörteil in einem integrierten Schaltkreis (IC) integriert.

Die Erfindung soll nachstehend anhand der Figuren 1 - 5 näher beschrieben werden.

Es zeigen:

Fig. 1 ein Blockschaltbild für die Signalverarbeitung mit einem Schalter im Entstörteil,

Fig. 2a den zeitlichen Verlauf des verarbeiteten Eingangssignals,

Fig. 2b den zeitlichen Verlauf des Ausgangssignals der Schaltung,

Fig. 3 ein Blockschaltbild für die Signalverarbeitung mit einem Umschalter im Entstörteil,

Fig. 4a den zeitlichen Verlauf der verarbeiteten Eingangssignale,

Fig. 4b den zeitlichen Verlauf des Ausgangssignals bei einer Schaltung gemäß der Figur 3,

Fig. 5 ein Anwendungsbeispiel für die Schaltung in einem Audioprozessor.

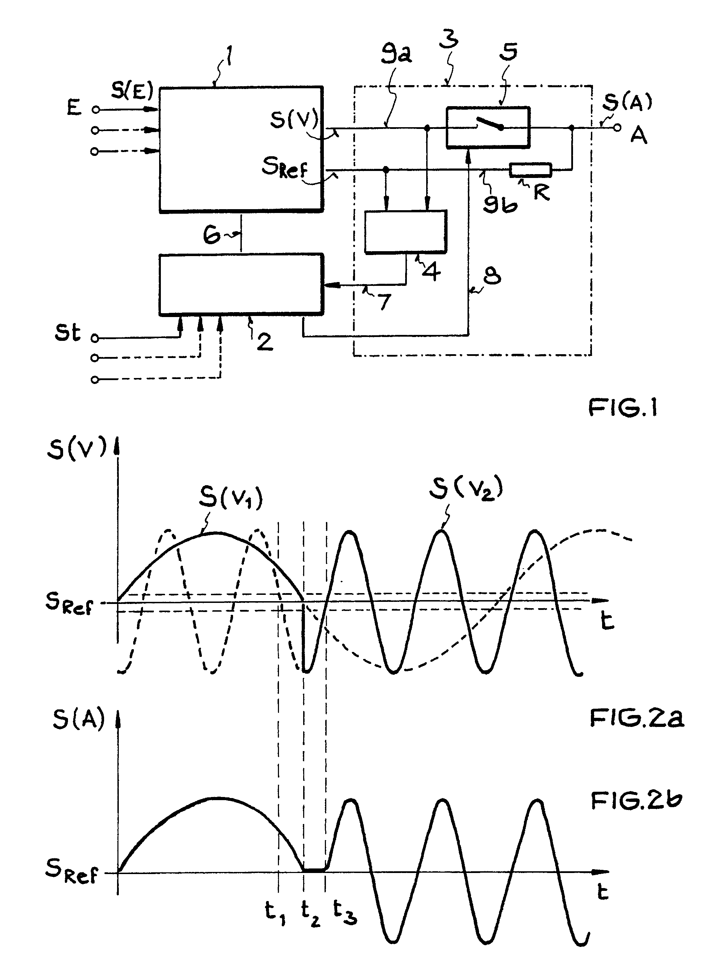

Gemäß der Figur 1 enthält die Schaltung einen Signalverarbeitungsteil 1 mit dem Eingang E, einen Logikteil 2 mit dem Steuereingang St und einem Entstörteil 3. Das zu verarbeitende Eingangssignal $S(E)$ liegt am Eingang E des Signalverarbeitungsteils 1 an, an dessen Ausgang das verarbeitete Eingangssignal $S(V)$ sowie ein Referenzsignal $S_{ref}$, dieses ist ein Maß für den DC-Versatz des Wechselspannungssignals.

Über den Steuereingang St des Logikteils 2, das durch Leitungen 6 mit dem Signalverarbeitungsteil 1 verbunden ist, kann ein Wunsch zum Signalwechsel, d. h. zur Änderung der Verarbeitung des aktuellen Signals, angemeldet werden; ein derartiger Änderungswunsch betrifft beispielsweise die Phase oder Amplitude des zu verarbeitenden Eingangssignals $S(E)$.

Anstatt nun diesem Änderungswunsch sofort nach zugeben und damit das verarbeitete Signal $S(V_1)$ abrupt zu ändern, was, wie eingangs erwähnt, mit Störungen des Ausgangssignals $S(A)$ verbunden ist, wird die Information über die gewünschte Änderung abgespeichert und mit Hilfe des Entstörteils 3 der Schaltung mit der Ausgabe des neuen aktuellen Signals $S(V_2)$ am Schaltungsausgang A so lange gewartet, bis das aktuelle Signal $S(V_2)$ den gleichen Signalpegel wie das Referenzsignal $S_{Ref}$ besitzt. Dies bedeutet, daß zwar im Signalverlauf des verarbeiteten Eingangssignals $S(V)$ ein Sprung auftritt, aber nicht am Schaltungsausgang A im Verlauf des Signals $S(A)$, so daß am Ausgang A auch keine Störungen ausgegeben werden.

Der Entstörteil 3 besteht dabei im wesentlichen aus einem Vergleicher 4 und einem elektronischen Schalter 5. Der Vergleicher 4 vergleicht die Signalpegel des verarbeiteten Eingangssignals $S(V)$ und des Referenzsignals $S_{Ref}$, die an den Verbindungsleitungen 9a bzw. 9b anliegen, und gibt bei Gleichheit dieser Signale über die Signalleitung 7 eine Rückmeldung an den Logikteil 2. Der Schalter 5, mittels dessen entschieden wird, ob das verarbeitete Eingangssignal S(V) auf den Ausgang A gegeben wird oder nicht, wird vom Logikteil 2 über die Leitung 8 entweder geöffnet oder geschlossen.

Das zeitliche Verhalten der Schaltung wird anhand der Figuren 2a und 2b deutlich; in der Figur 2a ist derzeitliche Verlauf des verarbeiteten Eingangssignals S(V) nach dem Signalverarbeitungsteil 1, bezogen auf das Referenzsignal $S_{Ref}$, und in Figur 2b der zeitliche Verlauf des "entstörten" Signals S(A) (d. h. des Ausgangssignals) dargestellt.

Zum Zeitpunkt $t_1$ erhält die Schaltung die Information zur Änderung an der Steuerleitung St des Logikteils 2 und speichert diese ab. Beim nächsten Nulldurchgang des ursprünglichen verarbeiteten Eingangssignals $S(V_1)$ zum Zeitpunkt $t_2$, den der Vergleicher 4 erkennt und an den Logikteil 2 weitermeldet, wird mittels des Schalters 5 das Signal $S(V_1)$ am Ausgang A abgeschaltet sowie über die Leitung 6 an den Signalverarbeitungteil 1 ein Freigabesignal zur Auslösung der Signaländerung vom alten Signal $S(V_1)$ zum neuen Signal $S(V_2)$ ausgegeben. Der Schaltungsausgang A wird nach dem Abschalten des Signals $S(V_1)$ durch die Leitung 9b mit dem Widerstand R auf dem Pegel des Referenzsignals $S_{Ref}$ gehalten (Figur 2b). Beim nächsten Nulldurchgang des nun aktuellen Signals $S(V_2)$ zum Zeitpunkt $t_3$, den wiederum der Vergleicher 4 erkennt und an den Logikteil 2 über die Leitung 7 weitermeldet, wird der Schalter 5 über die Leitung 8 geöffnet, und somit ein Durchschalten des verarbeiteten neuen Signals $S(V_2)$ zum Schaltungsausgang A ohne Sprünge oder Spitzen ermöglicht. Da Verstärker in der Signalverarbeitung einen DC-Offset besitzen und das verarbeitete Signal sehr klein sein kann, muß der Vergleicher 4 die Gleichheit zwischen verarbeitetem Eingangssignal S(V) und Referenzsignal $S_{Ref}$ in einem bestimmten Bereich um das Referenzsignal $S_{Ref}$ herum an den Logikteil 2 weitermelden; dieser Bereich um das Referenzsignal $S_{Ref}$, der in Figur 2a gestrichelt eingezeichnet ist, kann in Abhängigkeit der Größe des Offsets gewählt werden.

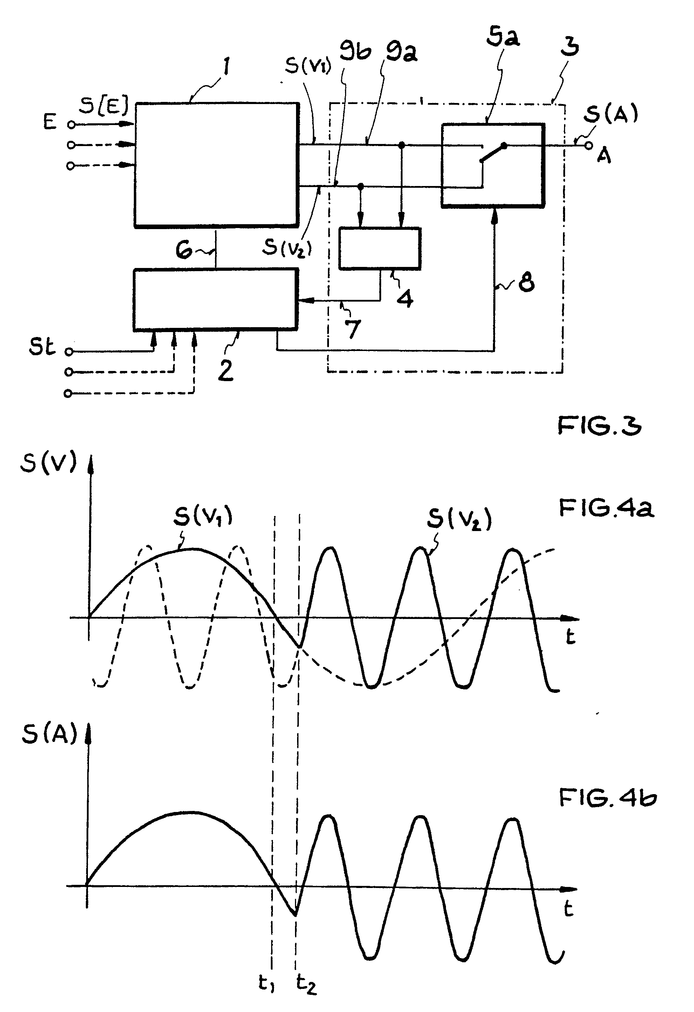

Gemäß der Schaltungsanordnung in der Figur 3 besitzt der Entstörteil 3 einen Umschalter 5a und einen Vergleicher 4, wobei am ersten Eingang des Umschalters 5a über die Verbindungsleitung 9a das erste verarbeitete Eingangssignal $S(V_1)$ und am zweiten Eingang des Umschalters 5a über die Verbindungsleitung 9b das zweite verarbeitete Eingangssignal $S(V_2)$ anliegt. Der elektronische Umschalter 5a wird über eine Verbindungsleitung 8 vom Logikteil 2 derart gesteuert, daß der Umschalter 5a umgeschaltet wird, wenn ein Änderungssignal am Logikteil 2 anlag

(Zeitpunkt $t_1$ in Figur 4a) und das erste verarbeitete Eingangssignal $S(V_1)$ gleich dem zweiten verarbeiteten Eingangssignal $S(V_2)$ ist; dies ist zum Zeitpunkt $t_2$ (Figur 4a) der Fall. Die Gleichheit der beiden verarbeiteten Eingangssignale wird dabei durch den Vergleicher 4 detektiert, der bei Gleichheit der beiden Eingangssignale $S_1(V)$ und $S_2(V)$ ein Steuersignal über die Verbindungsleitung 7 an den Logikteil mit der Maßgabe abgibt, daß das Signal $S(V_2)$ am Schaltungsausgang A ausgegeben werden darf. Der zeitliche Verlauf des Ausgangssignals S(A) ist in der Figur 4b dargestellt; das verarbeitete, ursprüngliche Eingangssignal $S_1(V)$ wird so lange am Ausgang A ausgegeben, bis ein störungsfreies Umschalten vom Signal $S(V_1)$ zum Signal $S(V_2)$ bzw. ein störungsfreier Wechsel der Signalverarbeitung, bei Gleichheit der beiden Signale $S(V_1)$ und $S(V_2)$ zum Zeitpunkt $t_2$ möglich ist.

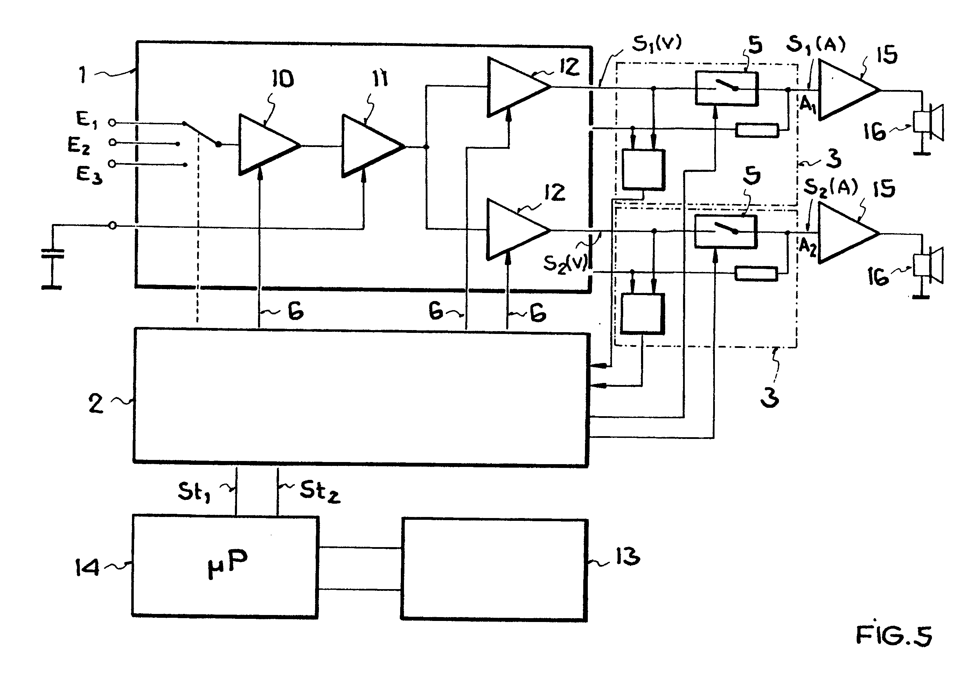

Gemäß der Figur 5 ist als Ausführungsbeispiel der erfindungsgemäßen Schaltung ein digital gesteuerter Audioprozessor dargestellt. Der Signalverarbeitungsteil 1 besitzt eine Schaltergruppe $E_1$ bis $E_3$, die zum Umschalten der Signalquelle dient; beispielsweise kann $E_1$ den FM-Teil, $E_2$ den AM-Teil und $E_3$ den Kassettenteil symbolisieren. Die weiteren Komponenten des Signalverarbeitungsteils 1 sind ein Vorverstärker 10, ein Baß-Treble-Glied 11 und zwei Endverstärker 12, die zwei verarbeitete Eingangssignale $S_1(V)$ und $S_2(V)$ ausgeben.

Über die Bedienungseinheit 13 kann ein Änderungswunsch vorgegeben werden, der über einen Mikroprozessor 14 und ein Bussystem $St_1$, $St_2$ auf den Logikteil 2 und von dort über die Leitungen 6 auf die einzelnen Komponenten 10, 11, 12 des Signalverarbeitungsteils 1 weitergegeben wird. Durch die beiden Entstörteile 3 der Schaltung werden Störsignale bei den verarbeiteten NF-Signalen $S_1(V)$, $S_2(V)$ ausgeblendet und die bereinigten Ausgangssignale $S_1(A)$ und $S_2(A)$ über die Leistungsverstärker 15 und die beiden Lautsprecher 16 ausgegeben. Bei dieser Schaltungsanordnung können Umschalt-Knackgeräusche in den Lautsprechern 16 vermieden werden. Die gesamte Schaltung kann bis auf die Leistungsverstärker 15, die wegen ihrer Verlustleistung extern liegen müssen, in einem IC integriert werden.

Die Verarbeitung des Signals in del erfindungsgemäßen Schaltung kann beispielsweise eine Verstärkungsänderung, Filterwirkung, Pegelumschaltung oder ein Phasenschieben sein.

### Ansprüche

1) Schaltung zur Signalverarbeitung symmetrischer Signale, bestehend aus einem Signalverarbeitungsteil (1) mit mindestens einem Eingang (E), an dem das zu verarbeitende Eingangssignal (S(E)) anliegt und mindestens einem Ausgang, an dem das verarbeitete Eingangssignal (S(V)) ansteht, sowie aus einem Logikteil (2) mit mindestens einem Steuereingang (St), an dem ein Steuersignal anliegt und mindestens einer Steuerleitung (6), mit der Steuersignale zur Änderung der Signalverarbeitung vom Logikteil zum Signalverarbeitungsteil (1) übertragen werden, dadurch gekennzeichnet, daß ein sowohl mit dem Ausgang des Signalverarbeitungsteils (1) als auch mit dem Logikteil (2) verbundener Entstörteil (3) vorgesehen ist, durch den der zeitliche Verlauf des verarbeiteten Eingangssignals (S(V)) derart erfaßt und dem Logikteil (2) zugeführt wird, daß das durch Steuersignale ausgelöste Umschalten und/oder ein Wechsel der Verarbeitung der Eingangssignale (S(E)) nur im Nulldurchgang oder bei möglichst geringer momentaner Signalspannung des verarbeiteten Eingangssignals (S(V)) oder bei möglichst kleinen Momentanwertunterschieden zwischen dem in der Verarbeitung geänderten Signal sowie dem ungeänderten Signal am Schaltungsausgang (A) auftritt.

2) Schaltung nach Anspruch 1, dadurch gekennzeichnet, daß der Entstörteil (3) einen Schalter (5) und Vergleicher (4) besitzt.

3) Schaltung nach Anspruch 2, dadurch gekennzeichnet, daß am Eingang des Schalters (5) das verarbeitete Eingangssignal (S(V)) und am Ausgang des Schalters das Ausgangssignal (S(A)) anliegt, daß der Vergleicher (4) als Eingangssignal über Verbindungsleitungen (9a bzw. 9b) das verarbeitete Eingangssignal (S(V)) sowie ein Referenzsignal (S_{Ref}) erhält und sein Ausgangssignal über eine Verbindungsleitung (7) an den Logikteil (2) abgibt.

4) Schaltung nach einem der Ansprüche 1 bis 3, dadurch gekennzeichnet, daß bei geschlossenem Schalter (5) über eine erste Verbindungsleitung (9a) das verarbeitete Eingangssignal (S(V)), und bei geöffnetem Schalter (5) über eine zweite Verbindungsleitung (9b) das Referenzsignal (S_{Ref}) auf den Schaltungsausgang (A) übertragen wird.

5) Schaltung nach Anspruch 4, dadurch gekennzeichnet, daß der elektronische Schalter (5) über eine Verbindungsleitung (8) vom Logikteil (2) derart gesteuert wird, daß der Schalter (5) geöffnet wird, wenn ein Änderungssignal (St) am Logikteil (2) anliegt oder anlag und sich das verarbeitete Eingangssignal (S(V_1)) im Nulldurchgang befindet (Zeitpunkt $t_2$), und daß der Schalter (5) geschlossen wird, wenn sich das geänderte verarbeitete Eingangssignal (S(V_2)) im Nulldurchgang befindet (Zeitpunkt $t_3$).

6) Schaltung nach einem der vorangehenden Ansprüche, dadurch gekennzeichnet, daß der Nulldurchgang des verarbeiteten Eingangssignals (S-

(V)) auf ein Referenzsignal (S_{Ref}) bezogen wird, daß dieser Nulldurchgang vom Vergleicher (4) detektiert wird, und daß bei Gleichheit der beiden Eingangssignale (S(V), S_{Ref}) der Vergleicher (4) ein Steuersignal über die Verbindungsleitung (7) an den Logikteil (2) abgibt.

7) Schaltung nach Anspruch 6, dadurch gekennzeichnet, daß der Vergleicher (4) die Gleichheit der Eingangssignale (S(V), S_{Ref}) in einem gewissen Bereich um das Referenzsignal (S_{Ref}) detektiert.

8) Schaltung nach Anspruch 1, dadurch gekennzeichnet, daß der Entstörteil (3) einen Umschalter (5a) und Vergleicher (4) besitzt.

9) Schaltung nach Anspruch 8, dadurch gekennzeichnet, daß am ersten Eingang des Umschalters (5a) das erste verarbeitete Eingangssignal (S(V_1)), am zweiten Eingang des Umschalters (5a) das zweite verarbeitete Eingangssignal (S(V_2)) und am Ausgang des Umschalters (5a) das Ausgangssignal (S(A)) anliegt, daß der Vergleicher (4) als Eingangssignal über Verbindungsleitungen (9a bzw. 9b) das erste verarbeitete Eingangssignal (S(V_1)) sowie das zweite verarbeitete Eingangssignal (S(V_2)) erhält und sein Ausgangssignal über eine Verbindungsleitung (7) an den Logikteil (2) abgibt (Fig. 3).

10) Schaltung nach Anspruch 9, dadurch gekennzeichnet, daß der elektronische Umschalter (5a) über eine Verbindungsleitung (8) vom Logikteil (2) derart gesteuert wird, daß der Umschalter (5a) umgeschaltet wird, wenn ein Änderungssignal (St) am Logikteil (2) anliegt oder anlag und das erste verarbeitete Eingangssignal (S(V_1)) gleich dem zweiten verarbeiteten Eingangssignal (S(V_2)) ist (Zeitpunkt $t_2$).

11) Schaltung nach Anspruch 10, dadurch gekennzeichnet, daß die Gleichheit der beiden verarbeiteten Eingangssignale (S(V_1), S(V_2)) durch den Vergleicher (4) detektiert wird, und daß bei Gleichheit der beiden Eingangssignale (S(V_1), S(V_2)) der Vergleicher (4) ein Steuersignal über die Verbindungsleitung (7) an den Logikteil (2) abgibt.

12) Schaltung nach einem der vorangehenden Ansprüche, dadurch gekennzeichnet, daß Signalverarbeitungsteil (1), Logikteil (2), Entstörteil (3) sowie die Verbindungsleitungen (6, 7, 8, 9a, 9b) in einem IC integriert sind.

13) Schaltung nach einem der vorangehenden Ansprüche, dadurch gekennzeichnet, daß die Signalverarbeitung des Eingangssignals S(E) eine Verstärkungsänderung, Filterwirkung, Pegelumschaltung oder Phasenänderung ist.

14) Schaltung nach einem der vorangehenden Ansprüche, gekennzeichnet durch ihre Verwendung in Audioprozessoren zur Vermeidung von Störungen im Lautsprecher (16) beim Umschalten der NF-Signale.

FIG.1

FIG.2a

FIG.2b

FIG.3

FIG.4a

FIG.4b

6

FIG.5

EP 0 416 522 A2